# EUROPEAN PATENT SPECIFICATION

(11) **EP 2 597 895 B1**
(45) Date of publication and mention of the grant of the patent: **13.04.2016**
(21) Application number: 12178417.7
(22) Date of filing: 30.07.2012
(51) Int. Cl.: H04R 25/00

(54) **Hearing instrument and method for manufacturing a hearing in-strument**
Hörinstrument und Verfahren zur Herstellung eines Hörinstruments
Instrument auditif et procédé de fabrication d'un instrument auditif

(30) Priority: 28.11.2011 US 201161563873 P
(43) Date of publication of application: 29.05.2013
(73) Proprietor: Sivantos Pte. Ltd., Singapore 139959 (SG)
(72) Inventor: Naumann, Frank, 91052 Erlangen (DE); Kral, Holger, 90766 Fürth (DE); Gebert, Anton, 91077 Kleinsendelbach (DE); Gommel, Uli, Singapore 589643 (SG)
(74) Representative: FDST Patentanwälte

(56) References cited:
- WO-A1-2011/078216
- US-A1- 2005 105 749
- US-A1- 2008 298 621

## Description

This invention relates to a hearing instrument comprising a microphone and a method for manufacturing such a hearing instrument.

A hearing instrument, for example a hearing aid, needs a microphone to receive acoustical signals from the environment. These microphones must be small to manufacture small hearing instruments. The hearing aid can for example be of the so-called behind-the-ear (BTE) type.

Currently hearing instruments have electret microphones with a separate housing, e.g. a metal housing, which often has the geometric shape of a box or a cylinder. This microphone housing is integrated into the housing of the hearing instrument. A microphone housing made of a metal provides electromagnetic compatibility (EMC), i.e. the metal housing acts as an EMC shield.

Within the housing there is the membrane and electronic components. The membrane divides the housing into two volumes in front of and behind the membrane, respectively. These two volumes are called back volume and front volume. Both volumes have a high impact on the performance of the microphone. The housing is assembled into a basic frame which keeps the microphone in a certain position. This basic frame connects the microphone housing to the housing of the hearing instrument and, thus, determines the position of the microphone housing in the hearing instrument. The basic frame is usually made of plastic.

The European patent application EP 1 517 584 A2 discloses a hearing aid comprising a microphone without a separate microphone housing. Instead, the microphone housing is an integrated part of the hearing aid housing itself.

Document US 2005/0105749 A1 proposes dispensing with a separate microphone housing and embodying said housing in one piece with the hearing device housing.

Document WO 2011/078216 A1 discloses a microphone unit. The microphone unit comprises a first and second vibrating part and a case for accommodating the vibrating parts. In an embodiment, a conductive coating layer is provided to an installation part and a lid of the microphone unit.

The problem underlying the herewith presented invention is to provide an electromagnetic shielding for a microphone in a hearing aid without a separate microphone housing made of metal.

This problem is solved by a hearing aid according to claim 1 and by a method for manufacturing a hearing aid according to claim 9.

Dependent claims cover preferred embodiments of the invention.

By providing a coating of electrically conducting material, e.g. a metal, to the surface of the cavity into which the microphone is inserted an electromagnetic shielding is provided in an easy manner. This shielding effectively prevents electromagnetic influences to affect the microphone.

The acoustic properties of the hearing aid are improved by arranging the microphone in the cavity of the basic frame such that a membrane of the microphone forms part of a closed surface which seals the cavity. Thereby the back volume is acoustically sealed.

Preferably the microphone is not directly inserted into the cavity, but rather attached to a microphone carrier, which is connected to the basic frame such that the back volume is sealed. The microphone carrier can be shaped as required more easily and - as a larger structure than the rather small microphone itself - handled more easily.

The microphone carrier can also include additional electronic components, e.g. for sound processing. This helps to further reduce the required space and to insert or exchange the sound carrier including the microphone and electrical components as one unit.

By soldering the microphone carrier into the cavity a continuous electromagnetic shielding can be provided excluding any gap between the coating of the cavity and microphone carrier. The solder paste provides an electrically conducting contact between the coating and the carrier. Alternatively, an electrically conducting glue can be used to attach the microphone carrier to the basic frame.

The electrically conducting material can be applied either to the inside or to the outside of the cavity. Both alternatives provide an effective electromagnetic shielding.

Preferably the coating is extended beyond the cavity on the outside surface of the basic frame to provide a reliably shielding.

By making the basic frame as a molded interconnected device (MID) the coating is applied easily and in various shapes of the cavity. This makes it possible to use the limited space available efficiently as back volume. Alternatively the electrically conductive coating can be applied by means of vapor coating.

The surface area of the basic frame which is to be coated can easily be defined by laser direct structuring (LDS).

Although the invention has been mostly addressed in the embodiment of a hearings instrument the invention can also be embodied as method for manufacturing such a hearing instrument. Features and advantages describer in reference to the device will therefore also imply corresponding features and advantages in the context of the method, and vice versa.

Embodiments of the inventions will now be described in more detail in reference to the figures.
- FIG. 1: Side view onto a hearing aid with a microphone;
- FIG. 2: top view onto a microphone carrier with a microphone, an electrical component and electrical contacts;
- FIG. 3: cross-sectional side view of the microphone carrier according to figure 2 inserted into a cavity of a basic frame of a hearing aid;
- FIG. 4: illustration of a method for manufacturing a hearing aid.

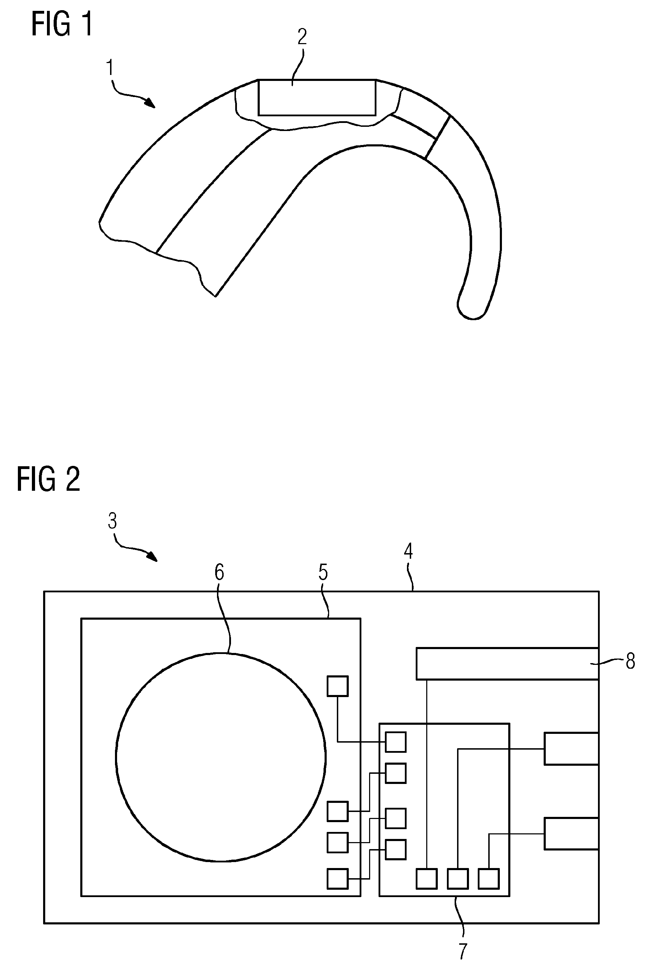

**Figure 1** shows a hearing instrument 1 in form of a behind-the-ear (BTE) hearing aid. It is partly cut open to illustrate the position of a microphone assembly 2.

As shown, the hearing aid can be of the BTE type. However, the microphone assembly 2 can also be used in a separate outer housing which is electrically connected to the main body of the hearing aid. Such a two-parted design of a hearing aid is known in the art.

The hearing instrument 1 comprises a basic frame, often called "neutral base", which provides the basic structure of hearing instrument 1. The components of the hearing aid 1 are connected to this frame. The basic frame will include cavities which are adapted to receive at least some of these components. Components might have separate cavities in the frame or might be included together into a bigger space.

The hearing instrument may contain one or more microphone arrangements, which can be integrated in separate cavities.

**Figure 2** shows the basic components of a microphone arrangement 3 integrated onto a microphone carrier 4. The microphone arrangement 3 includes a silicium microphone 5 with membrane 6 and an electric component 7 in form of an application-specific integrated circuit (ASIC). The ASIC 7 is connected to electric contacts 8 on the right of the microphone carrier 4. An electric signals of the silicium microphone 5 can be send to other parts of the hearings instruments 1 via these contacts 8 for further processing.

Although in this embodiment a silicium microphone 5 is used, with this invention either electret or silicium microphones can be used. Silicium microphones have the advantage to be less sensitive to structure-borne noise and hence they are better suited to be directly integrated into the hearing aid 1 without any damping arrangement.

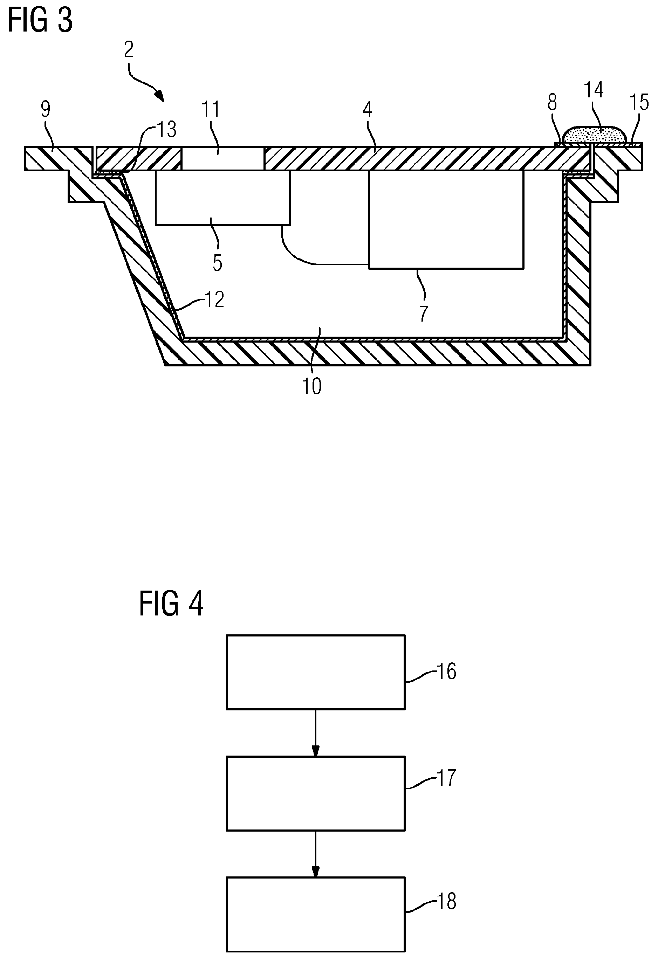

**Figure 3** shows how the microphone arrangement 3 of figure 2 is integrated into the basic frame 9 of the hearing aid 1. Only a part of the basic frame 9 is shown which can have further cavities for further microphone and other components. The microphone carrier 4 is integrated into the cavity, such that it closes the opening of the cavity. The ASIC 7 is connected to other components of the hearing instrument via the electric contacts 8.

In this cross-sectional view one can see that the silicium microphone 5 is placed behind a sound passage 11 through the microphone carrier 4. This allows sound from outside of the hearing instrument 1 to pass through the microphone carrier 4 to the membrane 6 of the silicium microphone 5.

The microphone is inserted into a cavity of the basic frame 9, which is usually made of plastic, which does not provide an EMC shielding.

The inside surface of the cavity is coated with a metalized EMC structure 12, which provides an EMC shielding. The coating 12 can be made of a metal or alternatively of any other electrically conducting material. In fact, coating can be applied on the inside or the outside of the cavity. Alternatively, the part of the basic frame 9 forming the cavity can be made conducting by any means other than coating. Additionally the microphone carrier 4 is connected to the basic frame 9 by soldering or gluing. This connection improves the EMC shield in that it closes any gap between the basic frame and the microphone carrier 4. Solder paste connections 13 connect the metal coating 12 with the microphone carrier 4.

To solder the microphone carrier 4 to the basic frame 9, solder paste is dispensed around the flange of the plastic cavity, afterwards the microphone carrier 4 is placed and both parts are soldered together in a solder oven. Soldering is anyway required for other purposed so this option would reduce the number of required steps.

The microphone 5 is included into the cavity such that the membrane 6 forms part of a closed surface which seals the cavity acoustically. Preferably this surface is also made part of the EMC shield so that the microphone 5 is enclosed completely by this EMC shield. In this embodiment the closed surface is at least partly defined by the microphone carrier 4, which can for example be a mostly flat structure, usually a flat printed-circuit board (PCB). This PCB may be equipped with an additional electrically conductive layer as part of the EMC shielding. The metallic coating 12 of the cavity together with the electrically connected conductive layer in the PCB of the microphone carrier 4 form the EMC shield.

On the outside connection between the basic frame 9 and the microphone carrier 4 an additional solder paste connection 14 can be made, which electrically connects the electric contacts 8 of the microphone carrier 4 with corresponding electric connectors 15 on the basic frame 9. In this embodiment of the invention the electronic contacts 8 are arranged on a different side of the microphone carrier 4 compared to figure 2.

The microphone 5 is included in the hearing aid 1 without a separate microphone housing directly into the microphone cavity of the basic frame 9. At least the membrane 6 of the microphone 5 will be included into this cavity. Additionally the electronic component 7 for processing the electronic signals for the microphone might also be included into this cavity, as shown in this embodiment. The basic frame 9 is made of plastic, but it can also be made of any other suitable material.

The microphone cavity has an opening into which the microphone carrier 4 is inserted. It is inserted and attached to the basic frame 9 such that membrane 6 of the microphone 5 is part of a sealing surface which separates the front volume from the back volume 10. In fact, the arrangement in this embodiment is such that the front volume is not included in the basic frame 9. However, in an alternative embodiment the front volume can be included in the basic frame 9. In such a case, the front volume will have an acoustic connection to the outside of the hearing aid 1.

The majority of the cavity is used a back volume 10. Generally it is the aim to make to back volume 10 as large as possible to improve the acoustic properties of the hearing aid 1. Another part of the cavity could be used as front volume, so that both front and back volume 10 are realized within the cavity.

A separate housing for the microphone 5 can be avoided, which reduces the costs and the constructional complexity of the hearing instrument 1.

By integrating the microphone 5 into the basic frame 9 the shape of the complete microphone assembly is determined primarily by the cavity. It is easy to adjust the shape of the cavity to the shape of hearing instrument 1 and/or the arrangement of other components as to use the available space as efficient as possible. The shape of the microphone arrangement is not anymore predetermined by the shape of the separate microphone housing. For a given shape of the hearing instruments 1 the total volume of the front and/or back volume 10 can be increased, which is beneficial for the acoustical properties.

Therefore it is now possible to build smaller hearing instruments 1 with same microphone performance or hearing instruments 1 of same size with better microphone performance.

Additionally the freedom of shaping the cavity, and hence the front and/or back volume 10, allows to customize the acoustic properties. This can be used for so-called frequency-shaping.

The complexity of the microphone integration is reduced since less parts are required, for example less complex PCBs.

The robustness of the hearing instrument 1 is increased since there are less parts, especially moving parts.

The costs are reduces, since it is easier to manufacture the hearing instrument 1. Less PCBs are required.

**Figure 4** illustrates the basic steps of a method of manufacturing a hearing instrument 1.

In the first step 16 the basic frame 9 with the cavity to receive the microphone carrier 4 is provided. In the second step 17 the metal coating 12 is applied to the inner surface of the cavity. In the third step the microphone carrier 4 with the microphone 5 is inserted into the cavity, such that the microphone carrier 4 together with the cavity define the back volume 10 of the microphone 5.

The basic frame 9 is preferably made as so-called "Molded Interconnected Device" (MID). Preferably it is manufactured using Laser Direct Structuring (LDS). By using LDS a designated surface area of the basic frame 9 is prepared to receive the metal coating 12.

With this technology it is possible to create local closed metalized structures 12 at plastic parts. This structure forms part of the EMC shield.

## Claims

1. Hearing instrument (1) comprising:
- a basic frame (9) with a cavity;
- a microphone (5) inserted into the cavity, such that the microphone (5) together with the cavity define a back volume (10) of the microphone (5); and
- a coating (12) made of an electrically conducting material applied to the surface of the cavity,
wherein the microphone (5) is attached to a microphone carrier (4), which is connected to the basic frame (9) such that the back volume (10) is sealed,
wherein the microphone carrier (4) is soldered, or glued using an electrically conducting glue, into the cavity such that a continuous electromagnetic shielding is provided excluding any gap between the coating (12) of the cavity and the microphone carrier (4).

2. Hearing instrument (1) according to claim 1, wherein the microphone (5) is arranged in the cavity such that a membrane (6) of the microphone (6) forms part of a closed surface which seals the cavity acoustically.

3. Hearing instrument (1) according to claim 1 or 2, wherein additional electronic components (7) are attached to the microphone carrier (4).

4. Hearing instrument (1) according to any of the claims 1 to 3, wherein the electrically conducting material is a metal.

5. Hearing instrument (1) according to any of the claims 1 to 4, wherein the electrically conducting material is applied to the inside or the outside of the cavity.

6. Hearing instrument (1) according to any of the claims 1 to 5, wherein the coating (12) is extended beyond the cavity on the outside surface of the basic frame (9).

7. Hearing instrument (1) according to any of the claims 1 to 6, wherein the basic frame (9) is made as a molded interconnected device.

8. Hearing instrument (1) according to any of the claims 1 to 7, wherein the coating (12) is applied by laser direct structuring.

9. Method for manufacturing a hearing instrument (1), comprising the steps of:
- providing a basic frame (9) with a cavity;
- applying a coating (12) of an electrically conducting material to the surface of the cavity; and
- inserting a microphone (5) into the cavity, such that the microphone (5) together with the cavity define a back volume (10) of the microphone (5),
wherein the microphone (5) is inserted into the cavity attached to a microphone carrier (4), which is connected to the basic frame (9) such the back volume (10) is sealed, wherein the microphone carrier (4) is soldered, or glued using an electrically conducting glue, into the cavity such that a continuous electromagnetic shielding is provided excluding any gap between the coating (12) of the cavity and the microphone carrier (4).

10. Method according to claim 9, wherein the basic frame (9) with its coating (12) is made as a molded interconnected device using laser direct structuring.

11. Method according to claim 9 or 10 adapted to manufacture a hearing instrument (1) according to any of the claims 1 to 10.

## Patentansprüche

1. Hörinstrument (1), das Folgendes umfasst:
- einen Basisrahmen (9) mit einem Hohlraum;
- ein in den Hohlraum eingesetztes Mikrofon (5), so dass das Mikrofon (5) zusammen mit dem Hohlraum ein hinteres Volumen (10) des Mikrofons (5) definieren; und
- eine aus einem stromleitenden Material hergestellte Beschichtung (12), die auf der Oberfläche des Hohlraums aufgebracht ist,
wobei das Mikrofon (5) an einem Mikrofonträger (4) angebracht ist, der derart mit dem Basisrahmen (9) verbunden ist, dass das hintere Volumen (10) abgedichtet ist,
wobei der Mikrofonträger (4) unter Verwendung eines stromleitenden Klebers derart in den Hohlraum gelötet oder geklebt ist, dass eine durchgehende elektromagnetische Abschirmung bereitgestellt wird, die jeglichen Spalt zwischen der Beschichtung (12) des Hohlraums und dem Mikrofonträger (4) ausschließt.

2. Hörinstrument (1) nach Anspruch 1, wobei das Mikrofon (5) derart im Hohlraum angeordnet ist, dass eine Membran (6) des Mikrofons (6) Teil einer geschlossenen Oberfläche bildet, die den Hohlraum akustisch abdichtet.

3. Hörinstrument (1) nach Anspruch 1 oder 2, wobei zusätzliche Elektronikkomponenten (7) an dem Mikrofonträger (4) angebracht sind.

4. Hörinstrument (1) nach einem der Ansprüche 1 bis 3, wobei das stromleitende Material ein Metall ist.

5. Hörinstrument (1) nach einem der Ansprüche 1 bis 4, wobei das stromleitende Material auf der Innenseite oder der Außenseite des Hohlraums aufgebracht ist.

6. Hörinstrument (1) nach einem der Ansprüche 1 bis 5, wobei die Beschichtung (12) über den Hohlraum hinaus auf der außenseitigen Oberfläche des Basisrahmens (9) erweitert ist.

7. Hörinstrument (1) nach einem der Ansprüche 1 bis 6, wobei der Basisrahmen (9) als eine ausgeformte verbundene Einrichtung hergestellt ist.

8. Hörinstrument (1) nach einem der Ansprüche 1 bis 7, wobei die Beschichtung (12) durch Laserdirektstrukturieren aufgebracht ist.

9. Verfahren zum Herstellen eines Hörinstruments (1), umfassend die folgenden Schritte:
- Bereitstellen eines Basisrahmens (9) mit einem Hohlraum;
- Aufbringen einer Beschichtung (12) aus einem stromleitenden Material auf der Oberfläche des Hohlraums; und
- Einsetzen eines Mikrofons (5) derart in den Hohlraum, dass das Mikrofon (5) zusammen mit dem Hohlraum ein hinteres Volumen (10) des Mikrofons (5) definiert,
wobei das Mikrofon (5) in den Hohlraum an einem Mikrofonträger (4) angebracht eingesetzt wird, der derart mit dem Basisrahmen (9) verbunden ist, dass das hintere Volumen (10) abgedichtet ist,
wobei der Mikrofonträger (4) unter Verwendung eines stromleitenden Klebers derart in den Hohlraum gelötet oder geklebt ist, dass eine durchgehende elektromagnetische Abschirmung bereitgestellt wird, die jeglichen Spalt zwischen der Beschichtung (12) des Hohlraums und dem Mikrofonträger (4) ausschließt.

10. Verfahren nach Anspruch 9, wobei der Basisrahmen (9) mit seiner Beschichtung (12) als eine ausgeformte verbundene Einrichtung unter Verwendung von Laserdirektstrukturieren hergestellt wird.

11. Verfahren nach Anspruch 9 oder 10, ausgelegt zum Herstellen eines Hörinstruments (1) gemäß einem der Ansprüche 1 bis 10.

## Revendications

1. Instrument auditif (1) comprenant :
- une armature de base (9) à cavité ;
- un microphone (5) inséré dans la cavité, de telle sorte que le microphone (5) avec la cavité définisse un volume arrière (10) du microphone (5) ; et
- un revêtement (12) réalisé en un matériau électriquement conducteur appliqué sur la surface de la cavité,
dans lequel le microphone (5) est attaché à un support de microphone (4), lequel est raccordé à l'armature de base (9) de façon à sceller le volume arrière (10),
dans lequel le support de microphone (4) est soudé ou collé en utilisant une colle électriquement conductrice dans la cavité de telle sorte qu'un blindage électromagnétique continu soit assuré, excluant tout interstice entre le revêtement (12) de la cavité et le support de microphone (4).

2. Instrument auditif (1) selon la revendication 1, dans lequel le microphone (5) est agencé dans la cavité de telle sorte qu'un diaphragme (6) du microphone (6) fasse partie d'une surface fermée qui scelle acoustiquement la cavité.

3. Instrument auditif (1) selon la revendication 1 ou 2, dans lequel des composants électroniques supplémentaires (7) sont attachés au support de microphone (4).

4. Instrument auditif (1) selon l'une quelconque des revendications 1 à 3, dans lequel le matériau électriquement conducteur est un métal.

5. Instrument auditif (1) selon l'une quelconque des revendications 1 à 4, dans lequel le matériau électriquement conducteur est appliqué sur l'intérieur ou l'extérieur de la cavité.

6. Instrument auditif (1) selon l'une quelconque des revendications 1 à 5, dans lequel le revêtement (12) est prolongé au-delà de la cavité sur la surface extérieure de l'armature de base (9).

7. Instrument auditif (1) selon l'une quelconque des revendications 1 à 6, dans lequel l'armature de base (9) est réalisée sous forme de dispositif interconnecté moulé.

8. Instrument auditif (1) selon l'une quelconque des revendications 1 à 7, dans lequel le revêtement (12) est appliqué par structuration directe au laser.

9. Procédé de fabrication d'un instrument auditif (1), comprenant les étapes consistant à :
- fournir une armature de base (9) à cavité ;
- appliquer un revêtement (12) d'un matériau électriquement conducteur sur la surface de la cavité ; et
- insérer un microphone (5) dans la cavité, de telle sorte que le microphone (5) avec la cavité définisse un volume arrière (10) du microphone (5) ; et
dans lequel le microphone (5) est inséré dans la cavité attaché à un support de microphone (4), lequel est raccordé à l'armature de base (9) de façon à sceller le volume arrière (10),
dans lequel le support de microphone (4) est soudé ou collé en utilisant une colle électriquement conductrice dans la cavité de telle sorte qu'un blindage électromagnétique continu soit assuré, excluant tout interstice entre le revêtement (12) de la cavité et le support de microphone (4).

10. Procédé selon la revendication 9, dans lequel l'armature de base (9) avec son revêtement (12) est réalisée sous forme de dispositif interconnecté moulé par structuration directe au laser.

11. Procédé selon la revendication 9 ou 10, adapté pour fabriquer un instrument auditif (1) selon l'une quelconque des revendications 1 à 10.
